**Europäisches Patentamt**

**European Patent Office**

**Office européen des brevets**

(19)

(11) Publication number : **0 113 975 B2**

(12)

# NEW EUROPEAN PATENT SPECIFICATION

(45) Date of publication of the new patent specification : **26.02.92 Bulletin 92/09**

(51) Int. Cl.[5] : **H03K 4/50, H03K 4/56**

(21) Application number : **83307620.1**

(22) Date of filing : **15.12.83**

(54) Controllable sweep generator.

(30) Priority : **17.01.83 US 458239**

(43) Date of publication of application : **25.07.84 Bulletin 84/30**

(45) Publication of the grant of the patent : **28.12.88 Bulletin 88/52**

(45) Mention of the opposition decision : **26.02.92 Bulletin 92/09**

(84) Designated Contracting States : **DE FR GB NL**

(56) References cited :
DE-A- 2 511 642
DE-A- 2 947 045
JP-A- 5 372 559
US-A- 2 602 151
US-A- 4 284 906
THE REVIEW OF SCIENTIFIC INSTRUMENTS, vol. 42, no. 2, February 1971, pages 204-209; N.L. ROY et al.: "A time interval selector and proportional delay generator"
PHILIPS DATA HANDBOOK, Signetics integrated circuits 1978, pages 445, 637, 684

(56) References cited :
PHILIPS TECHN. TIJDSCHRIFT, 40, no.2/3, 1980/81, pages 56-69, H. Dollekamp et al.: "P2CCD in 60 MHZ-oscilloscoop met digitaal beeidgeheugen".
P. HOROWITZ et al. "The art of electronics", 1980, CAMBRIDGE UNIVERSITY PRESS, Cambridge, pages 121, 410-413
U. TIETZE, CH. SCHENK, "Halbleiter-Schaltungstechnik", 5. Auflage, 1980, SPRINGER VERLAG, Berlin, pages 405, 440-443

(73) Proprietor : **TEKTRONIX, INC.**
Tektronix Industrial Park D/S Y3-121 4900 S.W. Griffith Drive P.O. Box 500
Beaverton Oregon 97077 (US)

(72) Inventor : **Ainsworth, Walter W.**
6725 S.W. Queen Lane
Beaverton Oregon 97005 (US)
Inventor : **Metz, Arthur J.**
12740 Frolov Drive, N.E.
Gervais Oregon 97026 (US)

(74) Representative : **Wombwell, Francis et al**
Potts, Kerr & Co. 15, Hamilton Square
Birkenhead Merseyside L41 6BR (GB)

EP 0 113 975 B2

## Description

### Background of the invention

The present invention relates generally to controllable sweep generators, and more particularly to a sweep generator for generating a sweep signal, the slope or sweep rate of which may be switched in predetermined steps.

Sweep (or ramp) generators are widely used in electronic instrumentation, one example of which is in an oscilloscope, wherein accurate sweep signals are generated in predetermined steps to provide the timebase of a quantitative waveform measurement. Sweep generators for typical oscilloscopes generate timebase sweep signals ranging from ten nanoseconds per screen division to five seconds per screen division in 1-2-5 steps.

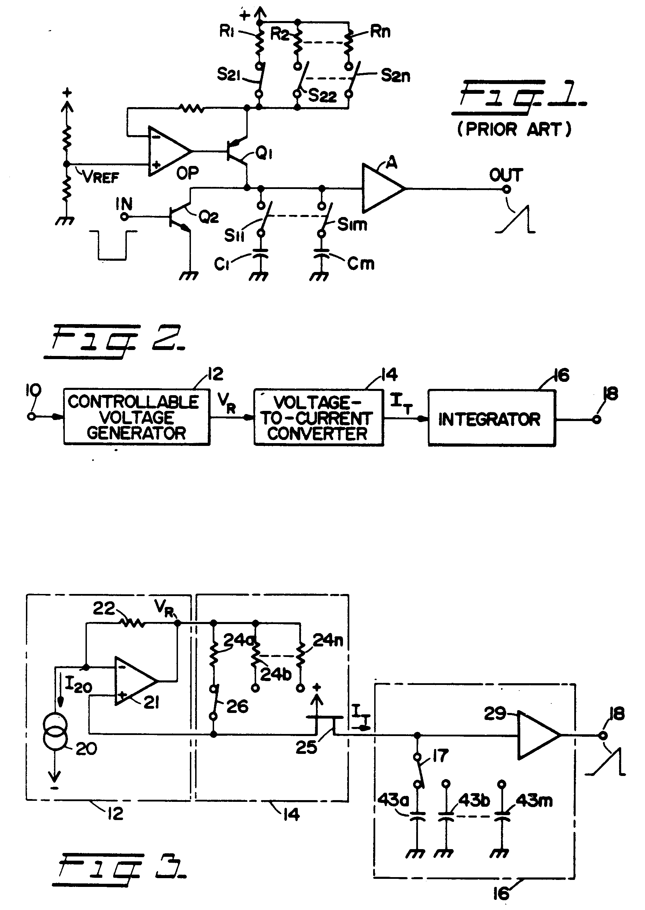

Shown in Fig. 1 is a conventional sweep generator which comprises a controllable current source including transistor $Q_1$, a plurality of timing resistors $R_1$, $R_2$, ..., $R_n$, switches $S_{21}$, $S_{22}$, ..., $S_{2n}$, and operational amplifier OP, a plurality of timing capacitors $C_1$, ..., $C_m$, switched by respective switches $S_{11}$, ..., $S_{1m}$, a gating transistor $Q_2$ and a buffer amplifier A. A reference voltage $V_{ref}$ is applied to the non-inverting input of operational amplifier OP to maintain the emitter potential of transistor $Q_1$ equal to $V_{ref}$ regardless of the output current from the controllable current source, i.e., the collector current of transistor $Q_1$, depending on the selected timing resistor $R_1$, $R_2$, ..., or $R_n$. Such output current is commonly referred to as a timing current and is utilized to charge the selected timing capacitor $C_1$, ..., or $C_m$ while gating transistor $Q_2$ remains non-conducting, thereby developing a linear ramp voltage across the timing capacitor to be made available via buffer amplifier A to output terminal OUT. The sweep rate is proportional to the timing current but inversely proportional to the capacitance of timing capacitor. Gating transistor $Q_2$ is turned on by applying a relatively positive voltage to the base thereof to discharge the timing capacitors $C_1$, ..., $C_m$, thereby forming a short retrace portion of the ramp signal. Buffer amplifier A may include a source follower field effect transistor (FET) input stage and an emitter follower output stage for impedance conversion, thereby minimizing changes in the timing current due to leakage (or bias current), which may cause timing error.

Disadvantages of the conventional sweep generator include the need for many precision timing elements (capacitors and resistors) including timing resistors in the order of ten kilohms to over ten megohms and difficulty in implementing electronic switches For example, any resistance in series with the timing capacitor would develop an undesirable voltage step when the timing current is supplied thereto. Such a voltage step is not negligible as the timing current becomes larger.

In addition, in an article entitled "A time interval selector and proportional delay generator" by N. L. Roy and D. G. Becker published in The Review of Scientific Instruments, Vol. 42, No. 2, Feb 1971, pages 204-209 a ramp generator and current source is described comprising all the features of the first part of claim 1.

### Summary of the invention

A controllable sweep generator according to the present invention is set forth in independent claim 1.

### Brief description of the drawings

Fig. 1 is a circuit schematic of a conventional sweep generator;
Fig. 2 is a simplified block diagram of a controllable sweep generator;
Fig. 3 is a simplified circuit schematic of a controllable sweep generator;
Fig. 4 is a circuit schematic of another controllable sweep generator;
Fig. 5 is a simplified circuit schematic of still another sweep generator;
Fig. 6 is a block diagram of a sweep integrator circuit according to the present invention;
Fig. 7 is a circuit schematic of an integrator associated with Fig. 6; and
Fig. 8 is a circuit schematic of a buffer amplifier for sweep signal output.

### Detailed description

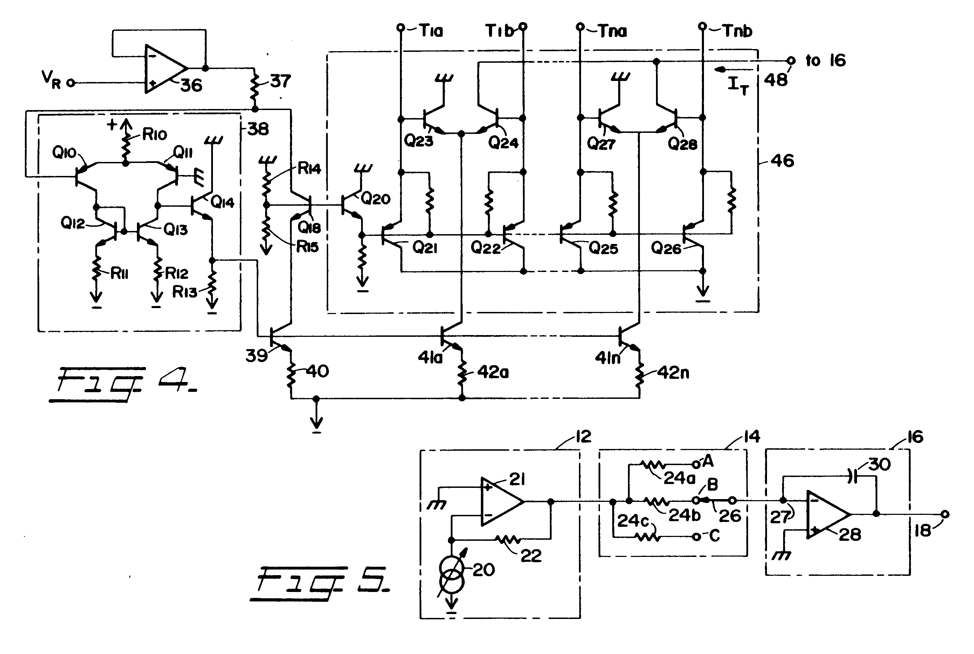

Referring now to Fig. 2 illustrating a simplified block diagram. The controllable sweep generator comprises three blocks: controllable voltage generator 12 to generate a plurality of output voltages $V_R$ under control of an input signal applied to input terminal 10, voltage-to-current converter 14 for converting the $V_R$ into the corresponding timing currents $I_T$, and integrator 16 integrating the current $I_T$ to develop an output sweep voltage to be available from output terminal 18 by way of a buffer amplifier as necessary.

Controllable voltage generator 12 may include a controllable current source, which may be operable under control of μP, and a current-to-voltage converter. The output voltage $V_R$ may suitable be in the range of 20 to 25 volts. Voltage-to-current converter 14 may include a plurality of resistors to generate a timing current of desired magnitude. Switching of such resistors may be performed by using electronic switches to facilitate control by a μP or any other digital control device. Integrator 16 may include a plurality of switchable timing capacitors or may be a Miller integrator. Although not shown in Fig. 2, a control signal or a sweep gate signal may be applied to integrator 16 for repetitive generation of the sweep signal by charging and discharging such timing capacitors.

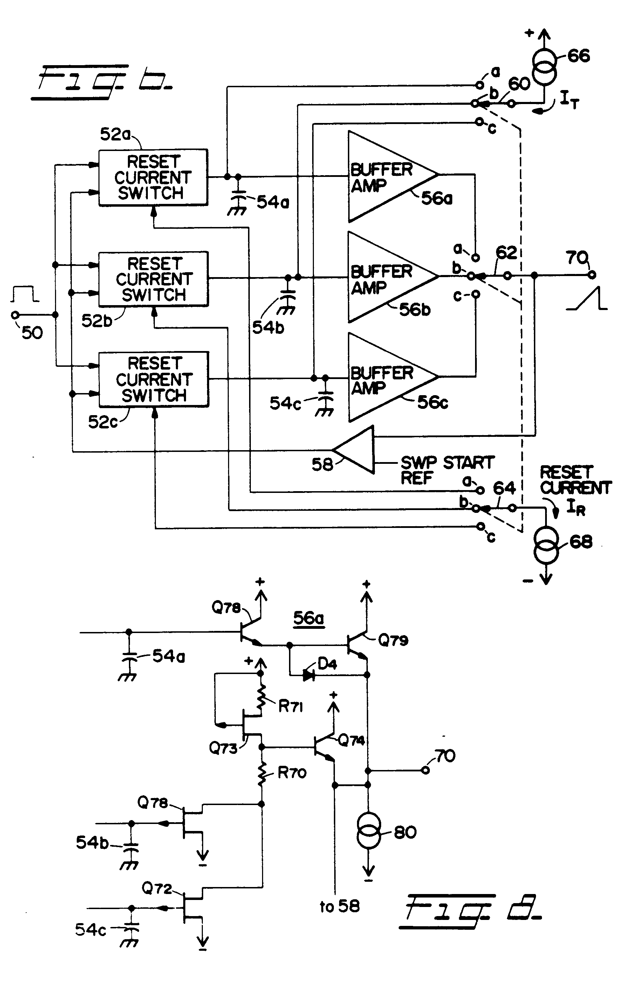

Shown in Fig. 3 is a circuit schematic of the controllable sweep generator. Controllable voltage generator 12 comprises in this particular circuit operational amplifier 21, current source 20 coupled to the inverting input of operational amplifier 21 and resistor 22 connected between the inverting input and the output terminals of operational amplifier 21. It is understood that the output voltage $V_R = I_{20} \times R_{22}$, where $I_{20}$ and $R_{22}$ represent respectively the output current from current source 20 and the resistance of feedback resistor 22. The $V_R$ is therefore controllable by varying either one or both of the values of $I_{20}$ and $R_{22}$. For precise control of voltage $V_R$, however, the current $I_{20}$ is normally controlled by utilizing, for example, a digital-to-analog converter (DAC) to receive a digital signal from a computer or similar control means.

The output voltage $V_R$ is then forced by operational amplifier 21 across a selected one of resistors $24_a$, $24_b$, ..., $24_n$ selected by switch 26 constituting voltage to current converter 14 along with FET 25, which may be replaced by a PNP transistor. Because of very high input impedance of operational amplifier 21, such as, for example, the one including an FET input stage, the current $I_{20}$ flows through feedback resistor 22. Similarly, the resulting current flowing through the selected resistor 24, which is substantially equal to $V_R/R_{24}$, flows only through the source-drain (or emitter-collector) path of transistor 25. The non-inverting input of operational amplifier 21 is maintained at a desired voltage by transistor 25 along with the gate (or base) bias network.

Integrator section 16 receiving the drain output current (timing current $I_T$) comprises a plurality of switchable capacitors $43_a$, $43_b$, ..., $43_n$ selected by switch 17 and buffer amplifier 29, which may include an FET input stage. It is understood that the timing current $I_T$ is directly proportional to the current $I_{20}$ (or the voltage $V_R$) and inversely proportional to resistance $R_{24}$ (the resistance of selected resistor $24_a$, $24_b$, ..., $24_n$). The sweep rate (slope) of the sweep signal is directly proportional to the current $I_T$ and inversely proportional to the capacitance of the selected timing capacitor 43. The sweep rates of the resulting sweep signal may be controlled over a wide range by proper control of current source 20, and switches 26 and 17. Timing current $I_T$ may be varied, for example, from ten microamperes to five milliamperes in 1-2-5 step sequence without using very large timing resistors.

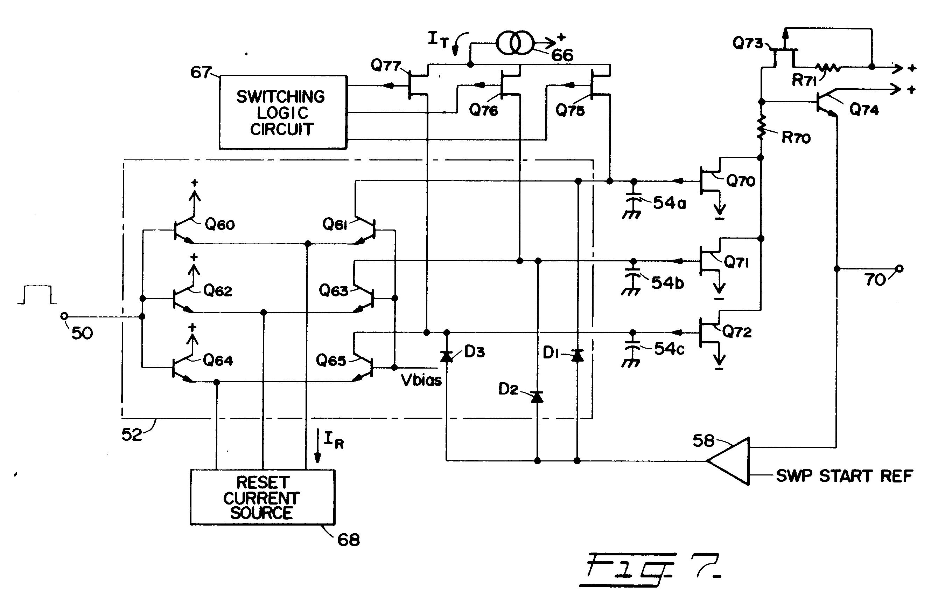

Shown in Fig. 4 is a circuit schematic of another sweep generator. Controllable voltage generator section for generating the voltage $V_R$ is not included in Fig. 4 for simplicity. The voltage $V_R$ generated by any desired generator similar to the one in Fig. 3 or described hereinafter is first applied to one end of input resistor 37 by way of buffer amplifier 36. The other end of input resistor 37 is applied to the non-inverting input of operational amplifier 38 comprising transistors $Q_{10}$ through $Q_{14}$, and resistors $R_{10}$ through $R_{13}$. Transistors $Q_{10}$ and $Q_{11}$ comprise an emitter coupled transistor pair with the base of transistor $Q_{11}$, the inverting input, referenced to ground. Transistors $Q_{12}$ and $Q_{13}$ form a current mirror circuit. The collector of transistor $Q_{11}$ is coupled to the base of transistor $Q_{14}$, providing an emitter follower amplifier. The emitter output of transistor $Q_{14}$ is applied to the base of transistor 39, the collector of which is fed back to the non-inverting input of operational amplifier 38 by way of the common base transistor $Q_{18}$. A reference voltage provided by resistive divider comprising resistors $R_{14}$ and $R_{15}$ is applied to the base of transistor $Q_{18}$. The emitter of transistor 39 is returned to a negative voltage source through resistor 40.

A plurality of current source transistors $41_a$, , $41_n$ including respective programmed emitter resistors $42_a$, ..., $42_n$ are connected in parallel with transistor 39. Connected to the collectors of transistors $41_a$, ..., $41_n$ is a switching circuit 46 to provide a controllable timing current $I_T$ to integrator 16 through output terminal 48 under control of a logic control signal applied to control terminals $T_{1a}$, $T_{1b}$, ..., $T_{na}$, $T_{nb}$. The collector of transistor $41_a$ is coupled to the common emitter junction of emitter coupled transistor pair $Q_{23}$-$Q_{24}$. Similarly, the collector of transistor $41_n$ is coupled to the emitter junction of emitter coupled transistors $Q_{27}$-$Q_{28}$. Voltage swing on the bases of transistors $Q_{23}$, $Q_{24}$, $Q_{27}$ and $Q_{28}$ is determined by respective transistors $Q_{21}$, $Q_{22}$, $Q_{25}$ and $Q_{26}$, the bases of which are coupled to the base of transistor $Q_{18}$ by way of emitter follower transistor $Q_{20}$ for buffer and temperature compensation purposes. Coupled to the bases of transistors $Q_{23}$, $Q_{24}$, $Q_{27}$ and $Q_{28}$ are control terminals $T_{1a}$, $T_{1b}$, ..., $T_{na}$ and $T_{nb}$. One collector output of each emitter coupled transistor pair $Q_{23}$-$Q_{24}$, ..., $Q_{27}$-$Q_{28}$ is grounded but the other collector outputs are coupled in common to output terminal 48.

In operation, operational amplifier 38 amplifies the input signal thereto in such a manner that the entire current $(V_R/R_{37})$ flows from collector to emitter through transistor $Q_{18}$ and then to the emitter of transistor 39, thereby setting the base voltage of transistor 39, $41_a$, ..., $41_n$ substantially equal to

$$\frac{R_{40}}{R_{37}} V_R.$$

The collector current of the transistor $41_a$ is substantially equal to

$$\frac{R_{40}}{R_{37} R_{42a}} V_R.$$

Similarly, the collector current of transistor $41_n$ is substantially equal to

$$\frac{R_{40}}{R_{37} R_{42n}} V_R.$$

This suggests that the collector current of transistor

$41_a$, ..., $41_n$ is inversely proportional to the respective emitter resistor $42_a$, ..., $42_n$. Such collector current is routed to output terminal 48 when a relatively high control voltage is applied to control terminals $T_{1b}$, $T_{2b}$, ..., $T_{nb}$, but bypassed to ground when a relatively high control voltage is applied to the other control terminals $T_{1a}$, $T_{2a}$, ..., $T_{na}$. Such selected timing current $I_T$ is supplied to integrator 16 to charge timing capacitor, thereby developing a linear ramp signal thereacross.

As is understood from the foregoing description, controllable voltage $V_R$, resistance of resistors $42_a$, ...,$42_n$ are controlled so as to provide the programmable sweep voltage. Such selection may be made by controlling the digital signal applied to control terminals $T_{1a}$, $T_{1b}$, ..., $T_{na}$, $T_{nb}$ in addition to the input signal to control voltage generator 12. The resistance of resistor 37 may also be switched as necessary. Note that the above-described programmable current source may be used as current source 20 in Fig. 3.

Fig. 6 shows a simplified block diagram of integrator circuit according to the present invention. This is particularly suited for switching one timing capacitor of a plurality of timing capacitors by electronic switching means. Applied to terminal 50 is a sweep gate pulse to control the generation of termination of the sweep signal. In this particular embodiment, three independent timing capacitors $54_a$, $54_b$, and $54_c$ and respective control circuits are used. Three reset current switch and disconnect diode circuits $52_a$, $52_b$, and $52_c$ receive the sweep gate signal applied to control terminal 50, reset current $I_R$ from reset current source 68 by way of switch 64, and the output from sweep start regulator 58. A timing current $I_T$ from current source 66 is supplied to timing capacitor $54_a$, $54_b$, or $54_c$ selectively through switch 60. The sweep voltage across each timing capacitor $54_a$ through $54_c$ is respectively coupled to output terminal 70 by way of respective buffer amplifier $56_a$ through $56_c$ and switch 62. Switches 60, 62 and 64 are intercoupled to operate simultaneously to select one of timing capacitors $52_a$, $52_b$ and $52_c$. The output voltage on output terminal 70 is applied to one input of comparator or sweep start regulator 58 which compares the quiescent output voltage with a sweep start reference level applied to the other input of such regulator 58. It is to be understood that while three timing capacitors are shown for this embodiment, the system may be expanded to include any desired number of timing capacitors.

In operation, all of the switches 60, 62, and 64 are set to the upper portion "a" to select the first timing capacitor $54_a$. During the sweep period of the sweep gate signal applied to control terminal 50, the timing current $I_T$ is routed into timing capacitor $54_a$, thereby developing a ramp voltage thereacross. Such ramp voltage is supplied to output terminal 70 through buffer amplifier $56_a$ and switch 62. Similarly, the second or third timing capacitor $54_b$ or $54_c$ is chosen by setting switches 60, 62 and 64 to the middle position "b" or the lower position "c". When the sweep period is terminated, respective reset current switch and disconnect diode $52_a$, $52_b$ or $52_c$ is activated to discharge the respective timing capacitor, thereby forming the retrace portion of the ramp signal. Reset current $I_R$ is always larger than timing current $I_T$. Sweep start regulator 58 is used to establish a constant sweep start level by forming a closed loop circuit including the selected timing capacitor 54 and its associated circuits 52 and 56.

This circuit arrangement is particularly useful to avoid any error or voltage step mentioned earlier due to the residual resistance or reactance of the switch connected in series with such timing capacitor. In addition, no stray capacitance of an "off" switching device is added to the timing capacitor, thereby avoiding any timing error. It should be noted that buffer amplifier 56 is directly coupled across the respective timing capacitor because of the use of independent buffer amplifier and control circuit. As is described hereinafter, optimum buffer circuit may be used as each buffer amplifier $56_a$, $56_b$ or $56_c$.

The integrator block of Fig. 6 will be better understood by reference to Fig. 7 illustrating a circuit schematic of one practical embodiment. Reset current switch and disconnect diode circuit 52 comprises three emitter coupled transistor pairs $Q_{60}$-$Q_{61}$, $Q_{62}$-$Q_{63}$ and $Q_{64}$-$Q_{65}$ and three diodes $D_1$, $D_2$ and $D_3$. The bases of transistors $Q_{60}$, $Q_{62}$ and $Q_{64}$ are connected in common to control terminal 50 while the bases of transistors $Q_{61}$, $Q_{63}$ and $Q_{65}$ are connected to a suitable bias voltage source $V_{bias}$. The emitter node of each transistor pair is connected to reset current source 68. The collectors of transistors $Q_{60}$, $Q_{62}$ and $Q_{64}$ are connected to a positive voltage source while the collectors of transistors $Q_{61}$, $Q_{63}$ and $Q_{65}$ are respectively connected to timing capacitors $54_a$, $54_b$ and $54_c$. Anodes of three diodes $D_1$, $D_2$ and $D_3$ are coupled in common to the output of sweep start regulator 58 while the cathodes of such diodes are coupled respectively to timing capacitors $54_a$, $54_b$ and $54_c$.

Timing current source 66 is selectively coupled to timing capacitor $54_a$, $54_b$ or $54_c$ by way of respective current-steering FETs $Q_{75}$, $Q_{76}$ or $Q_{77}$ which are under control of switching logic circuit 67. Although not shown in Fig. 7, similar switching devices and a control logic circuit are included in reset current source 68.

Buffer amplifiers 56 comprise three FETs $Q_{70}$, $Q_{71}$ and $Q_{72}$, current source FET $Q_{73}$, resistors $R_{70}$ and $R_{71}$ and emitter follower output transistor $Q_{74}$. The gates of FETs $Q_{70}$, $Q_{71}$ and $Q_{72}$ are coupled to respective timing capacitors $54_a$, $54_b$, and $54_c$. The sources of FETs $Q_{70}$ through $Q_{72}$ are connected together to the lower end of resistors $R_{70}$, the upper end of which is connected to the base of transistor $Q_{74}$. The emitter of transistor $Q_{74}$ is connected to sweep start regulator 58 and defines output terminal 70 from which a linear ramp signal is produced. The outputs of the three buffer amplifiers are directly coupled and no selection switch representing switch 62 in Fig. 6 is employed in this particular embodiment.

In operation, assuming now that first timing capacitor $54_a$ is to be selected, logic control circuit 67 provides a low level only to the gate of FET $Q_{75}$ to steer all of timing current $I_T$ to the selected timing capacitor. Simultaneously, reset current source 68 is controlled to supply the reset current $I_R$ to the emitter node of first transistor pair $Q_{60}$-$Q_{61}$. As mentioned above, reset current $I_R$ is selected to be always larger than timing current $I_T$. During the retrace or quiescent condition of the sweep gate signal applied to control terminal 50, the base of transistor $Q_{60}$ is lower than $V_{bias}$, thereby making $Q_{61}$ conductive. Timing current $I_T$ from FET $Q_{75}$ and discharge current of timing capacitor $54_a$ flow through such transistor $Q_{61}$ during retrace. In the quiescent condition, timing capacitor $54_a$ is completely discharged, and the difference current equal to $(I_R$-$I_T)$ is supplied from start level regulator 58 through diode $D_1$, thereby completing the closed loop to maintain the sweep start level equal to the reference level (e.g, ground level) applied to sweep start regulator 58. Degeneration resistor $R_{71}$ helps determine the drain current of $Q_{73}$ operating as a current source. Resistor $R_{70}$ is used for proper DC offset.

A linear ramp (or sweep) voltage starts from the aforementioned reference level when the sweep gate voltage at control terminal 50 goes high, thereby turning transistor $Q_{61}$ off and transistor $Q_{60}$ on, shifting reset current $I_R$ to a power supply. The selected timing capacitor $54_a$ is now charged by the timing current $I_T$ at the rate proportional to the $I_T$ but inversely proportional to the capacitance of such timing capacitor. As the ramp voltage develops across such timing capacitor, diode $D_1$ is automatically disconnected. The ramp voltage is then transmitted to output terminal 70 through FET $Q_{70}$, resistor $R_{70}$, and emitter-follower transistor $Q_{74}$. A reset circuit (not shown) is normally utilized to reset the sweep gate pulse when the ramp voltage reaches a predetermined level, thereby starting the retrace portion of the sweep signal. The above operation may be repeated by controlling the sweep gate signal applied to control terminal 50. It should be pointed out that a logic circuit or other mechanism (also not shown) holds the gate of FETs $Q_{71}$ and $Q_{72}$ high when timing capacitor $54_a$ is selected.

Other timing capacitors $54_b$ or $54_c$ may be selected in the same manner to develop ramp signals of different sweep rates or slopes. FET $Q_{76}$ and second emitter coupled transistor pair $Q_{62}$-$Q_{63}$ are energized to select timing capacitor $54_b$. FET $Q_{71}$ and diode $D_2$ constitute part of the closed loop in this instance. Similarly, FET $Q_{77}$ and third transistor pair $Q_{64}$-$Q_{65}$ are energized to select timing capacitor $54_c$. FET $Q_{72}$ and

diode $D_3$ constitute part of the closed loop in this instance. A wide range of sweep signals are generated by simply utilizing a single current source $I_T$.

The use of the independent reset current switch/disconnect diode for each timing capacitor and current steering FETs $Q_{75}$ through $Q_{77}$ is responsible for deletion of a selector switch in series with the timing capacitor from which the ramp signal is derived. This is very useful in avoiding voltage steps, spikes, etc. which cause non-linearity of the ramp signal.

Although the buffer amplifiers connected to each timing capacitor are identical in this particular embodiment, different buffer amplifiers may be better suited for each sweep signal, i.e., a faster buffer amplifier for high speed. sweep signal. Fig. 8 shows a circuit schematic of such an example. Assuming that first timing capacitor $54_a$ is the lowest in capacitance for developing a high speed sweep signal, Darlington connected high frequency transistors $Q_{78}$ and $Q_{79}$ are used as buffer amplifier $56_a$ for such timing capacitor. Slight leakage current of the timing current $I_T$ may be caused because of the finite base bias current characteristic of bipolar transistors. However, such leakage or bias current may be minimized by using the Darlington connection of two high current gain transistors, increasing the timing current $I_T$, or controlling current source 80 in proportion to the $I_T$. Alternatively, very short channel high $f_T$ $_{MOS}$FET may be substituted for the Darlington transistors.

The foregoing description is made on preferred embodiments of this invention so that one having skill in the art can put the present invention into practice in any forms best suited to a particular application.

## Claims

1. A controllable sweep generator, comprising a voltage generator (12), a voltage-to-current converter (14, 66) for converting the output voltage from said voltage generator into a current for output to an integrator (16) for developing a linear ramp voltage therefrom wherein said voltage generator (12) is controllable to generate a plurality of output voltages ($V_R$) under the control of an input signal (10); said voltage-to-current converter (14, 66) converts said output voltages ($V_R$) into a plurality of timing currents ($I_T$) for input to said integrator (16), characterised in that said integrator includes

a plurality of timing capacitors (54) each connected at one end to a reference potential source;

a plurality of buffer amplifiers (56) respectively connected to the other end of said timing capacitors (54);

control means (67) for selectively supplying a timing current ($I_T$) to one of said timing capacitors (54) and for controlling the charging and discharging of said timing capacitors (54).

2. A controllable sweep generator in accordance with claim 1, further including a reset current source (68) for selectively coupling a reset current ($I_R$) larger than said timing current ($I_T$) to the selected timing capacitor (54), and a start level regulator (58) for maintaining the start level of the sweep signal.

3. A controllable sweep generator in accordance with claim 1, wherein at least one of said buffer amplifiers uses Darlington transistors (78, 79).

4. A controllable sweep generator in accordance with claim 3, wherein a current source (80) responsive to the timing current is connected to the emitter of the output stage transistor of said Darlington transistors (78, 79).

5. A controllable sweep generator according to claim 2, wherein the output of said start level regulator (58) is connected to each of said timing capacitors (54) through a diode (D1, D2, D3).

6. A controllable sweep generator according to claim 1, wherein said control means includes a plurality of emitter coupled transistor pairs to the emitters of which said reset current source (68) is selectively coupled.

## Patentansprüche

1. Steuerbarer Kippgenerator mit einem Spannungsgenerator (12), einem Spannung-Strom-Wandler (14, 66) zum Umwandeln der Ausgangsspannung vom Spannungsgenerator in einen Strom zur Ausgabe an einen Integrator (16), um daraus eine lineare Sägezahnspannung zu entwickeln, wobei der Spannungsgenerator (12) steuerbar ist, um eine Vielzahl von Ausgangsspannungen ($V_R$) unter der Steuerung eines Eingangssignals (10) zu erzeugen, und wobei der Spannung-Strom-Wandler (14, 66) die Ausgangsspannungen ($V_R$) in mehrere Zeitsteuerströme ($I_T$) zur Eingabe in den Integrator (16) umwandelt, dadurch gekennzeichnet, daß der Integrator

eine Vielzahl von Zeitsteuerkondensatoren (54), die jeweils an einem Ende mit einer Bezugspotentialquelle verbunden sind,

eine Vielzahl von Pufferverstärkern (56), die jeweils mit dem anderen Ende der Zeitsteuerkondensatoren (54) verbunden sind, und

Steuereinrichtungen (67) zum wahlweisen Zuführen eines Zeitsteuerstromes ($I_T$) zu einem der Zeitsteuerkondensatoren (54) und zum Steuern des Aufladens und Entladens der Zeitsteuerkondensatoren (54) enthält.

2. Steuerbarer Kippgenerator nach Anspruch 1, welcher weiterhin eine Rücksetzstromquelle (68) zum wahlweisen Zuführen eines Rücksetzstromes ($I_R$) zu den gewählten Zeitsteuerkondensatoren (54), der größer als der Zeitsteuerstrom ($I_T$) ist, und einen Anfangspegelregler (58) zum Beibehalten des Anfangspegels des Kippsignals enthält.

3. Steuerbarer Kippgenerator nach Anspruch 1, bei dem wenigstens einer der Pufferverstärker Darlington-Transistoren (78, 79) verwendet.

4. Steuerbarer Kippgenerator nach Anspruch 3, bei dem eine Stromquelle (80), die auf den Zeitsteuerstrom anspricht, mit dem Emitter des Transistors der Ausgangsstufe der Darlington-Transistoren (78, 79) verbunden ist.

5. Steuerbarer Kippgenerator nach Anspruch 2, bei dem der Ausgang des Anfangspegelreglers (58) über eine Diode (D1, D2, D3) mit jedem Zeitsteuerkondensator (54) verbunden ist.

6. Steuerbarer Kippgenerator nach Anspruch 1, bei dem die Steuereinrichtung mehrere Transistorpaare in Emitter-Schaltung aufweist, mit deren Emittern die Rücksetzstromquelle (68) wahlweise verbunden ist.

## Revendications

1. Générateur de balayage commandé, comprenant un générateur de tension (12), un convertisseur tension-courant (14, 66) pour convertir la tension de sortie de ce générateur de tension en un courant destiné à être fourni à un intégrateur (16) pour produire une tension en rampe linéaire à partir de celui-ci, dans lequel ledit générateur de tension (12) peut être commandé pour produire une pluralité de tensions de sortie ($V_R$) sous la commande d'un signal d'entrée (10), ledit convertisseur tension-courant (14, 66) convertissant lesdites tensions de sortie ($V_R$) en une pluralité de courants de cadencement ($I_T$) destinés à être fournis à l'intégrateur (16), caractérisé en ce que ledit intégrateur comprend :

une pluralité de condensateurs de cadencement (54) reliés par une extrémité à une source de potentiel de référence,

une pluralité d'amplificateurs séparateurs (56) respectivement reliés à l'autre extrémité desdits condensateurs de cadencement (54),

des moyens de commande (67) pour fournir sélectivement un courant de cadencement ($I_T$) à l'un desdits condensateurs de cadencement (54) et pour commander la charge et la décharge desdits condensateurs de cadencement (54).

2. Générateur de balayage commandé selon la revendication 1, caractérisé en ce qu'il comprend en outre une source de courant de remise à l'état initial (68) pour fournir sélectivement un courant de remise à l'état initial ($I_R$) d'intensité plus grande que celle dudit courant de cadencement ($I_T$) au condensateur de cadencement sélectionné (54), et un régulateur de niveau de départ de balayage (58) pour maintenir constant le niveau de départ du signal de balayage.

3. Générateur de balayage commandé selon la revendication 1, caractérisé en ce qu'au moins l'un desdits amplificateurs séparateurs (56) utilise des transistors montés en Darlington (78, 79).

4. Générateur de balayage commandé selon la revendication 3, caractérisé en ce qu'une source de courant (80) sensible au courant de cadencement est reliée à l'émetteur du transistor de l'étage de sortie desdits transistors Darlington (78, 79).

5. Générateur de balayage commandé selon la revendication 2, caractérisé en ce que la sortie dudit régulateur de niveau de départ du balayage (58) est reliée à chacun desdits condensateurs de cadencement (54) par l'intermédiaire d'une diode ($D_1$, $D_2$, $D_3$).

6. Générateur de balayage commandé selon la revendication 1, caractérisé en ce que lesdits moyens de commande comportent une pluralité de paires de transistors reliés par l'émetteur, ladite source de courant de remise à l'état initial (68) étant sélectivement reliée à ces émetteurs.

Fig. 1.
(PRIOR ART)

Fig 2.

Fig 3.

**Fig 4.**

**Fig 5.**

9

_Fig. b._

52a

RESET CURRENT SWITCH

52b

RESET CURRENT SWITCH

52c

RESET CURRENT SWITCH

50

54a

54b

54c

BUFFER AMP 56a

BUFFER AMP 56b

BUFFER AMP 56c

58 SWP START REF

60

66

$I_T$

a
b
c

62

70

a
b
c

64

a
b
c

RESET CURRENT $I_R$

68

Q78

56a

Q79

D4

54a

R71

Q73

Q74

R70

70

Q78

80

54b

to 58

_Fig. d._

Q72

54c

Fig 7.